# EUROPÄISCHE PATENTSCHRIFT

(11) **EP 0 720 756 B1**
(45) Veröffentlichungstag und Bekanntmachung des Hinweises auf die Patenterteilung: **18.06.1997**
(21) Anmeldenummer: 94926193.7
(22) Anmeldetag: 13.08.1994
(51) Int. Cl.: G03F 7/20

(54) **VERFAHREN ZUR HERSTELLUNG VON MIKROSTRUKTURKÖRPERN**
PROCESS FOR PRODUCING MICROSTRUCTURE BODIES
PROCEDE DE PRODUCTION DE CORPS MICROSTRUCTURES

(30) Priorität: 22.09.1993 DE 4332108
(43) Veröffentlichungstag der Anmeldung: 10.07.1996
(73) Patentinhaber: Forschungszentrum Karlsruhe GmbH, 76133 Karlsruhe (DE)
(72) Erfinder: EL-KHOLI, Aida, 76344 Eggenstein-Leopoldshafen (DE); PANTENBURG, Franz-Josef, D-76646 Bruchsal (DE); MOHR, Jürgen, D-75056 Sulzfeld (DE); RENDL, Erwin, D-76149 Karlsruhe (DE)
(74) Vertreter: Rückert, Friedrich, Dr.
(86) Internationale Anmeldenummer: EP9402707
(87) Internationale Veröffentlichungsnummer: WO9508790

(56) Entgegenhaltungen:
- EP-A- 0 227 851
- REVIEW OF SCIENTIFIC INSTRUMENTS, Bd.63, Nr.1, Januar 1992, NEW YORK US Seiten 757 - 760, XP280861 O. KNÜPPEL ET AL 'Compact Synchrotron Radiation Depth Lithography Facility'
- DATABASE IBM-TDB ANONYMOUS 'Preparing Resists for Sculpturing Wall Profiles of Resists. February 1978.'

## Beschreibung

Die Erfindung betrifft ein Verfahren zur Herstellung von Mikrostrukturkörpern entsprechend dem Oberbegriff des Patentanspruchs.

Ein solches Verfahren ist beispielsweise aus den Kfk-Nachrichten, Jahrgang 23, 2-3/91, insbesondere aus den Artikeln "Stand und Entwicklungsziele des LIGA-Verfahrens zur Herstellung von Mikrostrukturen" von P. Bley und W. Menz (Seiten 69-75) und "Herstellung von Röntgenmasken für das LIGA-Verfahren" von W. Bacher et al (Seiten 76-83) bekannt.

Als Röntgenmaske werden Membranen aus Titan oder Titan mit Beryllium mit Absorbern aus Gold oder Chrom eingesetzt, die das gewünschte Muster aus durchlässigen und nicht durchlässigen Teilbereichen ergeben. Die metallischen Röntgenmasken werden parallel und in einem Abstand zu einer Schicht aus einem röntgenstrahlenempfindlichen Material justiert. Röntgenstrahlenempfindliche Materialien werden in der Mikrostrukturtechnik als Röntgenresist bezeichnet. Meist wird als Röntgenresistschicht Polymethylmethacrylat (PMMA) verwendet.

Jeder Röntgenresist weist eine charakteristische Grenzdosis auf; wird er in der Weise mit Röntgenlicht bestrahlt, daß die Grenzdosis überschritten wird, können die bestrahlten Stellen etwa mit den aus der DE 30 39 110 A1 bekannten Entwicklerlösungen herausgelöst werden. Nicht bestrahlte Stellen oder solche Stellen, an denen die Grenzdosis nicht überschritten ist, werden bei den üblichen Entwicklungsverfahren im allgemeinen nicht herausgelöst, zumindest dann nicht, wenn die Entwicklungsbedingungen sorgfältig kontrolliert werden. Die Grenzdosis beträgt für PMMA 3,5 kJ/cm². Röntgenresistmaterialien wie beispielsweise PMMA, die bei einer Bestrahlung oberhalb der Grenzdosis löslich werden, bezeichnet man als positive Restistmaterialien.

Wird die Kunststoffschicht in der üblichen Weise durch die Maske bestrahlt, können die bestrahlten Stellen durch den Entwickler herausgelöst werden, während die durch die Maske abgeschatteten Stellen nicht angegriffen werden. Auf diese Weise wird das Muster der Maske auf die Kunststoffschicht übertragen. Die zu bestrahlende Kunststoffschicht kann 20 bis 500 µm dick sein; durch geeignet gewählte Intensität der Bestrahlung kann dabei sichergestellt werden, daß auch in der Tiefe der Kunststoffschicht, etwa bis zu 500 µm unterhalb ihrer Oberfläche, die Grenzdosis überschritten ist. Damit lassen sich nach dem Entwickeln scharfkantige Mikrostrukturkörper mit glatten, senkrechten Wänden herstellen, die eine der Dicke der bestrahlten Kunststoffschicht entsprechende Höhe, etwa zwischen 20 und 500 µm, aufweisen.

Die Strahlungsbedingungen hängen außer von der Dicke der Kunststoffschicht von der Art der verwendeten Maske ab. Bei Masken mit Membranen aus Titan, deren strahlenundurchlässige Bereiche 2,3 µm dick sind, wird üblicherweise eine Röntgenstrahlung mit einer Energie im Bereich von 2,3 GeV bei einem Strom von 33 mA/min eingesetzt und für eine Zeitdauer von ca. 27 min aufrechterhalten, wenn der zu bestrahlende Röntgenresist bei einer Fläche von 60 · 10 mm (die der Strahlfläche entspricht) 200 µm dick ist.

Meist wird die mit Mikrostrukturkörpern versehene Kunststoffschicht nicht direkt verwendet, sondern sie wird galvanisch mit einem Metall abgeformt. Für die galvanische Abformung ist eine elektrisch leitende, zusammenhängende Schicht am Boden der Mikrostrukturkörper notwendig, die bei der galvanischen Abformung als Elektrode geschaltet wird.. Die einfachste Möglichkeit, eine solche elektrisch leitende, zusammenhängende Schicht am Boden der Mikrostrukturkörper zu schaffen, besteht darin, daß die Kunststoffschicht in gewünschter Dicke auf eine Metallplatte aufgetragen und in der beschriebenen Weise bestrahlt wird, so daß an den bestrahlten Stellen nach dem Entwickeln die Metallplatte freiliegt. Die Dicke der Kunststoffschicht bestimmt dann die Höhe der erzeugten Mikrostrukturkörper.

Es sind verschiedene Versuche unternommen worden, Mikrostrukturkörper herzustellen, deren Seitenwände nicht wie beim oben beschriebenen Verfahren senkrecht, sondern geneigt zur Ebene der Maske stehen, so daß die Seitenwände mit der Ebene der Maske keinen senkrechten Winkel einschließen.

Das exakteste Verfahren, solche Mikrostrukturkörper mit geneigten Seitenwänden herzustellen, ist in der DE 38 42 354 C2 beschrieben. Hierbei wird eine Kunststoffschicht zweifach mit Röntgenlicht bestrahlt, das jeweils eine Maske senkrecht durchdringt. Die Kunststoffschicht liegt jedoch nicht parallel zur Maskenebene, sondern ist bei der ersten Bestrahlung um einen Winkel +α, bei der zweiten Bestrahlung um einen Winkel - a relativ zur Maskenebene gedreht.

In der DE 38 42 354 C2 sind weitere Druckschriften zitiert, die sich ebenfalls mit der Herstellung von Mikrostrukturkörpern mit geneigten Seitenwänden befassen.

Gemäß der Veröffentlichung von J. Mohr, W. Ehrfeld und D. Münchmeyer, Kernforschungszentrum Karlsruhe, Bericht KfK-4414, Kapitel 2, werden die Auswirkungen einer relativ zur einfallenden Strahlung schräg stehenden Maske diskutiert. Danach lassen sich durch Schrägstellung der Maske Mikrostrukturkörper mit geneigten Seitenwänden, etwa mit dreieckigem oder trapezförmigem Querschnitt, herstellen. Es wird beschrieben, daß bei schräg stehenden Masken Reflexions- und Beugungseffekte beobachtet werden, die die Qualität der Struktur beeinträchtigen. Im Querschnitt konische Mikrostrukturkörper lassen sich herstellen, indem bei üblicher Anordnung Masken mit solchen durchlässigen Bereichen verwendet werden, die selbst geneigte Seitenwände aufweisen.

In der US-4,264,714 ist ein Verfahren zur Herstellung von Mikrostrukturkörpern mit geneigten Seitenwänden beschrieben, bei dem ein Glassubstrat auf einer Seite mit einer Maske belegt wird. Über der Maske wird ein negativer Photorestist aufgetragen. Der Photoresist wird durch das Glassubstrat mit Strahlung, die auf dem Substrat senkrecht auftrifft, bestrahlt. Da ein negativer Photoresist verwendet wird, werden bei der nachfolgenden Entwicklung nur die nicht bestrahlten Stellen des Photoresists entfernt, während die bestrahlten Stellen stehenbleiben. Das Verfahren ist auf negative Photoresists beschränkt.

Aus der DE 30 28 308 Al ist ein Verfahren zum Erzeugen von Reliefstrukturen aus strahlungsempfindlichen Lacken auf einem Substrat bekannt. Bei einer Ausführungsform dieses Verfahrens wird ein metallisiertes Substrat mit einer strahlenempfind-lichen Lackschicht versehen. In der Lackschicht wird im Vakuum mit Hilfe eines Elektronenstrahlschreibers eine Strahlendosis abgelagert, die die photoaktive Komponente des Lacks zerstört. Anschließend wird die Lackschicht in feuchter Atmosphäre einer ganzflächigen UV-Bestrahlung ausgesetzt. Bei der anschließenden Entwicklung werden nur diejenigen Bereiche der Lackschicht aufgelöst, die nicht von der Elektronenstrahlung getroffen werden. Das Verfahren läßt sich nicht auf die Röntgenbestrahlung röntgenstrahlenempfindlicher Materialien übertragen, weil bestrahlte Bereiche in jedem Fall durch die Entwicklung gelöst werden.

Aus der DE 33 37 315 C2 ist ein Photoresistmaterial und ein Verfahren zur Herstellung von negativen Bildmustern aus einem Photoresistmaterial auf einem Substrat bekannt. Bei diesem Verfahren wird eine Resistschicht aus einem zweifach lichtempfindlichen Photoresistmaterial auf dem Substrat erzeugt, die Resistschicht bildmäßig mit Strahlung im fernen UV belichtet, ganzflächig belichtet und entwickelt. Die doppelt belichteten Bereiche der Resistschicht bleiben bei der Entwicklung erhalten. Das Verfahren ist aus demselben Grund nicht auf die Röntgenbestrahlung von Röntgenresists übertragbar.

Die EP 0 227 851 A1 beschreibt ein Verfahren zur Herstellung von Strukturen aus Photolack mit geneigten Seitenwänden, bei dem eine Projektionsmaske für UV-Strahlung, die an den Rändern ihrer Öffnungen Streueffekte ergibt, zur bildmäßigen Bestrahlung einer Photolackschicht verwendet wird. Anschließend kann die Photolackschicht ganzflächig bestrahlt werden, wonach beim Entwickeln die gewünschten Strukturen mit den geneigten Seitenwänden entstehen.

Die Veröffentlichung in REVIEW OF SCIENTIFIC INSTRUMENTS, Bd. 63, Nr. 1, Januar 1992, NEW YORK US, Seiten 757-760, XP280861, O. Knüppel et al: "Compact Synchrotron Ratiation Depth - Lithography Facility" befaßt sich mit der Herstellung hoher, feiner Strukturen unter Verwendung von Synchrotron-, somit Röntgenstrahlung. Es werden verschiedene Effekte identifiziert, die die erzielbare Exaktheit der erhaltenen Strukturen einschränken. Einer dieser Effekte ist die Bildung von Sekundärelektronen an den Rändern der Projektionsmaske zum bildmäßigen Bestrahlen.

Aufgabe der Erfindung ist es, ein weiteres Verfahren anzugeben, mit dessen Hilfe Mikrostrukturkörper erzeugt werden können, die geneigte Seitenwände aufweisen. Für das Verfahren sollen positive Röntgenresists einsetzbar sein. Als Ergebnis des Verfahrens sollen Mikrostrukturkörper entstehen, die sich in Richtung auf ihre freie Stirnfläche verjüngen, so daß durch galvanische Abformung z. B. Netze oder Siebe herstellbar sind, deren Öffnungen auf einer Seite größer sind als auf der anderen Seite.

Die Aufgabe wird bei einem Verfahren der eingangs genannten Art durch das kennzeichnende Merkmal gelöst.

Es wurde gefunden, daß durch die Röntgenstrahlung, die auf die metallische Maske trifft, Fluorenzphotonen und Elektronen mit annähernd isotroper Verteilung freigesetzt werden. Die Röntgenstrahlung bewirkt beim Auftreffen auf dem Metall der Maske, daß deren Elektronen in einen höheren Energiezustand angehoben werden; nehmen die Metallatome wieder den Grundzustand ein, so wird Fluoreszenzlicht freigesetzt. Außerdem ist die Röntgenstrahlung bei den üblichen Bestrahlungsbedingungen in der Lage, aus den Metallatomen Elektronen vollständig heraus zuschlagen.

Naturgemäß macht sich diese Sekundärstrahlung in der Nachbarschaft der mit Röntgenlicht bestrahlten Stellen auf der Kunststoffschicht in besonderem Maße bemerkbar, da diese Stellen in geringem Abstand zu der Quelle dieser Sekundärstrahlung liegen. Bilden die mit Röntgenlicht bestrahlten Stellen beispielsweise ein wabenförmiges, hexagonales Gitter, entstehen nach der Entwicklung sechseckige Säulen mit einem Sechseck als Stirnfläche, wobei die Stirnfläche entlang ihrer Kanten einen Teil der Sekundärstrahlung absorbiert. Die Sekundärstrahlung dringt außerdem in Abhängigkeit von ihrer Höhe in die Säulen ein.

Die Sekundärstrahlung wird durch den Kunststoff absorbiert. Die der Quelle zunächstliegenden und oberflächlichen Bereiche der Kunststoffschicht werden daher von einer höheren Strahlungsdosis getroffen als die tieferliegenden und entfernteren Bereiche.

Unter normalen Umständen, also bei Resistschichten üblicher Dicke und bei den üblichen Bestrahlungsbedingungen, reicht die Sekundärstrahlung nicht aus, die getroffenen Stellen der Kunststoffschicht beim Entwicklungsvorgang herauszulösen. Die Sekundärstrahlung bewirkt beim Entwickeln keinen merklichen Effekt.

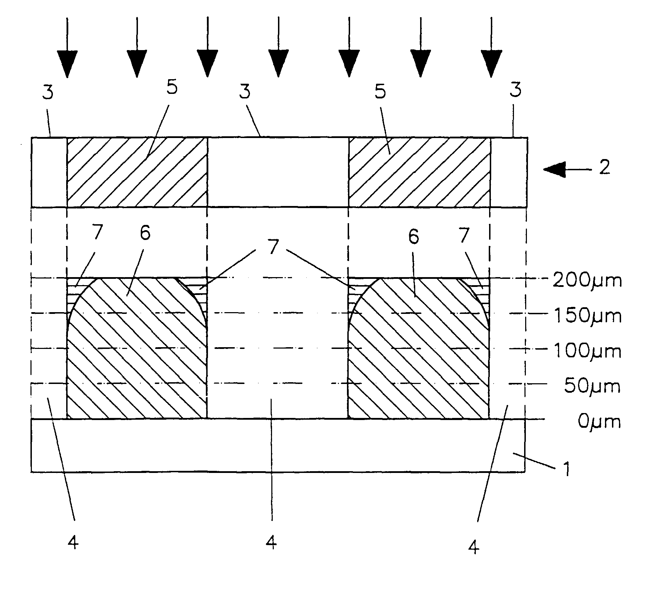

In der Figur sind die Verhältnisse nach der üblichen Bestrahlung durch die Maske und der nachfolgenden Entwicklung dargestellt.

Die Kunststoffschicht wurde im dargestellten Beispiel auf einer Metallplatte 1 in einer Dicke von 200 µm aufgetragen. Durch die Maske 2 wurde die Kunststoffschicht in üblicher Weise bestrahlt. Die den durchlässigen Teilbereichen 3 der Maske 2 gegenüberliegenden Stellen 4 der Kunststoffschicht wurden durch die Entwicklung entfernt, so daß nur noch die den undurchlässigen Teilbereichen 5 gegenüberliegenden Stellen 6 der Kunststoffschicht bestehen bleiben. Diese Stellen 6 bilden hier isolierte Säulen auf der Metallplatte. Ausgehend von der Stirnfläche der Säulen werden von der Sekundärstrahlung mit abnehmender Höhe immer dünnere ringförmige Bereiche 7 von der Sekundärstrahlung erfaßt. Der Verlauf der Strahlendosis ist in der Figur nicht dargestellt. Die Strahlendosis der Sekundärstrahlung ist an den Kanten der Stirnflächen am höchsten und nimmt in Richtung auf den Mittelpunkt der Stirnflächen und in Richtung auf die Metallplatte ab. Verbindet man die Orte gleicher Sekundärstrahlendosis miteinander, erhält man im Querschnitt die gekrümmte Linie, die in der Figur den Bereich 7 begrenzt.

Wie erwähnt, wird durch die Sekundärstrahlung die Grenzdosis des Röntgenresists üblicherweise nicht erreicht, so daß beim eingangs genannten Verfahren trotz der Sekundärstrahlung nach der Entwicklung Mikrostrukturkörper mit glatten, senkrecht verlaufenden Seitenwänden erhalten werden. Die Querschnittsflächen der Säulen sind damit in jeder Höhe identisch.

Erfindungsgemäß wird die Sekundärstrahlung ausgenutzt, um Mikrostrukturkörper zu erhalten, bei denen die Bereiche 7, die von der Sekundärstrahlung getroffen werden, beim Entwickeln ebenfalls herausgelöst werden. Hierzu wird vor dem Entwickeln die gesamte Oberfläche der Kunststoffschicht, somit sowohl die bereits bestrahlten als auch die nicht von der Röntgenstrahlung getroffenen Stellen, einer zweiten Röntgenbestrahlung ausgesetzt. Die zweite Röntgenbestrahlung wird so durchgeführt, daß die charakteristische Grenzdosis des Röntgenresist-materials nicht erreicht wird.

Die mit dem Bezugszeichen 7 markierten Stellen des Röntgenresists werden somit sowohl von der Sekundärstrahlung als auch von der zusätzlichen Röntgenbestrahlung getroffen. Hierdurch wird die Grenzdosis des Röntgenresists überschritten und die betreffenden Bereiche werden bei der Entwicklung löslich.

Die Intenstität und Dauer der zweiten, ganzflächigen Röntgenbestrahlung muß so gewählt werden, daß die Grenzdosis des Röntgenresistmaterials nicht erreicht wird, weil sonst auch von der Maske abgeschattete Stellen beim Entwickeln herausgelöst werden. Die Dosis der zusätzlichen Röntgenstrahlung addiert sich jedoch zu derjenigen Dosis, die durch die Sekundärstrahlung bewirkt wird, so daß an diesen Stellen die Grenzdosis des Resistmaterials überschritten wird und die betreffenden Stellen beim Entwickeln herausgelöst werden.

Wird die Kunststoffschicht bei der zweiten Bestrahlung von einer Dosis der Röntgenstrahlung getroffen, die nur wenig unterhalb der Grenzdosis des Resistmaterials liegt, so werden relativ große Bezirke der von der Sekundärstrahlung erfaßten Stellen des Kunststoffs beim Entwickeln herausgelöst, denn dann reicht eine geringe Dosis der Sekundärstrahlung aus, damit die Grenzdosis des Röntgenresists überschritten wird. Wird bei der zweiten Röntgenbestrahlung in der Kunststoffschicht eine wesentlich geringere Dosis als die Grenzdosis abgelagert, wird die Grenzdosis des Röntgenresists nur an den Bezirken der von der Sekundärstrahlung erfaßten Stellen überschritten, die eine hohe Dosis der Sekundärstrahlung erhalten. Dies sind bei säulenartigen Mikrostrukturkörpern die Bezirke, die den Kanten der Stirnflächen unmittelbar benachbart sind.

Durch die Dosis der zweiten Röntgenbestrahlung kann damit die Form der Mikrostrukturkörper beeinflußt werden. Das erfindungsgemäße Verfahren führt im Falle von säulenartigen Mikrostrukturkörpern zu einer Säulenform, die sich in Richtung auf die Stirnfläche verjüngt. Die Verjüngung ist im Querschnitt nicht linear, sondern entspricht - wie in der Figur angedeutet - einer gekrümmten Linie. Die Stirnflächen weisen eine ähnliche Querschnittsfläche auf wie der zur Stirnfläche parallele Querschnitt am Boden der Mikrostrukturkörper; ihre Fläche ist jedoch verkleinert. Das Maß der Verjüngung, also die Größe der Stirnfläche relativ zum hierzu parallelen Querschnitt am Boden des Mikrostrukturkörpers und die Höhe, ab der die Verjüngung einsetzt, sind von der Dosis der zweiten Bestrahlung abhängig.

Die zweite Bestrahlung muß nicht unbedingt nach der ersten Bestrahlung, die durch die Maske erfolgt, durchgeführt werden. Dieselben Verhältnisse stellen sich ein, wenn die zweite Bestrahlung vor der ersten Bestrahlung durchgeführt wird.

Die Erfindung wird im folgenden anhand eines Durchführungsbeispiels näher erläutert.

Durch eine Maske aus Titan, die an den nicht durchlässigen Bereichen 2,3 µm dick ist, wurde eine PMMA-Schicht unter den eingangs angegebenen Bedingungen mit 2,3 GeV-Röntgenstrahlung während einer Dauer von 27 min bestrahlt. Die Strahlungsrichtung verlief senkrecht zur Maskenebene und zur Ebene der PMMA-Schicht. Die PMMA-Schicht, die 200 µm dick war, wurde von einer Metallplatte gestützt.

Das Muster der Maske war so gewählt, daß die von der Strahlung erfaßten Stellen der PMMA-Schicht die Form eines honigwabenähnlichen, hexagonalen Gitters aufwiesen. Die Stegbreite des Gitters betrug ca. 45 µm und der Durchmesser der Sechsecke senkrecht zu zwei Kanten ca. 89 µm.

Anschließend wurde die Maske entfernt und die PMMA-Schicht ganzflächig ein zweitesmal mit Röntgenlicht bestrahlt. Die Energie des Röntgenlichts betrug wiederum 2,3 GeV; die Dauer der Bestrahlung lag bei jedoch bei 5 min. Danach wurde die PMMA-Schicht wie üblich entwickelt.

Es ergaben sich 200 µm hohe Mikrostrukturkörper in Form von Sechskantsäulen, die sich ab einer Höhe von 100 µm verjüngten. Die Seitenlängen der hexagonalen Stirnflächen war gegenüber den Seitenlängen der hierzu parallelen Querschnittsfläche am Boden der Säulen um den Faktor 0,6 kleiner. Die Kanten der Säulen bildeten im Verjüngungsbereich eine konkave, mit steigender Höhe zunehmend gekrümmte Linie.

## Patentansprüche

1. Verfahren zur Herstellung von Mikrostrukturkörpern durch Röntgenlithographie, bei dem ein röntgenstrahlempfindliches Material, das oberhalb einer charakteristischen Strahlengrenzdosis in einem Entwickler löslich wird, bildmäßig durch eine Röntgenlithographiemaske mit Röntgenstrahlung so lange bestrahlt, bis die Grenzdosis überschritten ist, und entwickelt wird, **dadurch gekennzeichnet, da**ß das Material vor oder nach der bildmäßigen Bestrahlung, jedoch vor dem Entwickeln vollflächig mit Röntgenstrahlen unterhalb der Grenzdosis bestrahlt wird.

## Claims

1. Method of producing microstructure bodies by X-ray lithography, wherein a material, which is sensitive to X-rays and becomes soluble in a developer above a characteristic limit dose of rays, is irradiated pictorially with X-radiation by an X-ray lithographic mask until the limit dose is exceeded and developed, characterised in that the material is irradiated with X-rays over its whole surface below the limit dose prior to or subsequent to the pictorial irradiation, but prior to the development.

## Revendications

1. Procédé de fabrication de corps microstructurés par lithographie aux rayons X dans lequel un matériau sensible au rayonnement par les rayons X, soluble dans un révélateur au-dessus d'une dose limite de rayons caractéristique, est irradié en fonction du format à travers un masque de lithographie aux rayons X, avec un rayonnement par les rayons X aussi longtemps jusqu'à ce que la dose limite soit dépassée et soit développé,
caractérisé en ce que
le matériau avant ou après l'irradiation en fonction du format, est irradié, cependant avant le développement, sur toute la surface avec des rayonnements à rayons X, en dessous de la dose limite.
